Europäisches Patentamt

European Patent Office

Office européen des brevets

(19)

(11) Publication number: **0 254 312**
**B1**

# EUROPEAN PATENT SPECIFICATION

(45) Date of publication of the patent specification:
07.11.90

(51) Int. Cl.⁵: **C30B 25/02**, C30B 29/04

(21) Application number: 87110686.0

(22) Date of filing: 23.07.87

(54) Method and apparatus for synthesizing diamond.

(30) Priority: 23.07.86  JP 173366/86
27.03.87  JP 75282/87

(43) Date of publication of application:
27.01.88 Bulletin 88/4

(45) Publication of the grant of the patent:
07.11.90 Bulletin 90/45

(84) Designated Contracting States:
DE FR GB SE

(56) References cited:
EP-A- 0 183 254

PATENT ABSTRACTS OF JAPAN, vol. 9,
no. 278 (C-312)[2001], 6th November 1985; &
JP-A-60 122 794 (MITSUBISHI KINZOKU K.K.) 01-07-1985
PATENT ABSTRACTS OF JAPAN, voi. 9,
no. 200 (C-298)[1923], 16th August 1985; &
JP-A-60 70 178 (NIPPON DENSHIN DENWA
KOSHA) 20-04-1985

(73) Proprietor: SUMITOMO ELECTRIC INDUSTRIES,
LIMITED, 15, Kitahama 5-chome Higashi-ku, Osaka-shi
Osaka-fu(JP)

(72) Inventor: Ikegaya, Akihiko Sumitomo Electric Ind.Ltd.,
Itami Works 1-1, Koyakita 1-chome, Itami City Hyogo
Prefecture(JP)
Inventor: Masaaki, Tobioka Sumitomo Electric Ind.Ltd.,
Itami Works 1-1, Koyakita 1-chome, Itami City Hyogo
Prefecture(JP)

(74) Representative: Hansen, Bernd, Dr.rer.nat. et al,
Hoffmann, Eitle & Partner Patentanwälte
Arabellastrasse 4 Postfach 81 04 20,
D-8000 München 81(DE)

**Description**

BACKGROUND OF THE INVENTION

< Field of the Invention >

The present invention relates to an improved vaporphase diamond synthesizing method, more particularly, to a method of synthesizing extremely consummate crystalline diamond which is almost free from carbon ingredient having structure other than diamond.

< Description of the Prior Art >

Conventionally, diamond is synthesized under presence of high temperature and high pressure with quite expensive processing cost. Recently, a variety of methods have been developed for synthesizing diamond under low pressure without applying ultra-high pressure. Typical examples are cited below.

(1) Japanese Patent Laid-Open No. 58-135117 (1983), Japanese Patent Application No. 61-8458 (1986), and Japanese Patent Application No. 61-8459 (1986) have respectively proposed plasma-applied highfrequency plasma CVD methods. Japanese Patent Laid-Open No. 59-3098 (1984), Japanese Patent Laid-Open No. 58-110494 (1983), and U.S. Patent No. 4,434,188, have respectively proposed microwave-applied plasma CVD methods.

(2) Some prior arts have proposed ionized vaporization method and ion-beam vaporization method by applying ionized particles.

(3) Japanese Patent Laid-Open No. 58-91100 (1983) has proposed thermoelectron radiating material CVD method by applying neutral ion.

(4) Japanese Patent Laid-Open No. 60-221395 (1985) (BP-161829) has proposed a CVD method by applying electron shower.

Of these, methods cited in (1) and (3) respectively allow the synthesis of crystalline diamond film. Those methods cited in (2) respectively generate non-crystalline diamond-like carbon film. The method cited in (4) generates better effect than others mentioned above by allowing the diamond film to grow itself at a faster rate, i.e., at 3 through 5 μm per hour rate. Furthermore, this method proved to have thickened the density of the diamond nucleus generated during the initial period of growing diamond film. However, this occurs only when the volume ratio between $CH_4$ and $H_2$, i.e., $CH_4/H_2$ rises. When this condition is present, according to Raman spectrum evaluation, peak of 1,550 $cm^{-1}$ belonging to amorphous carbon is too high, thus causing a problem of lowering the perfectness of diamond to easily occur. This is apparent from the description of J. Appl. Phys. 55 (1986) 640.

To securely generate bulk material, the diamond film growth rate is not yet sufficient.

Since crystalline diamond film is extremely rigid, those prior arts cited earlier have respectively proposed application of crystalline diamond film to the surface coating of wear-resistant parts, the surface of cutting tools to be coated, the heat-sink member of semiconductor device by effectively applying high thermal conductivity, and in addition, due to presence of considerable band gap, these prior arts positively study application of crystalline diamond film for making up semiconductor devices by means of doping impurities.

By applying microwave plasma CVD method, any of those prior arts cited earlier can generate diamond almost being free from amorphous carbon and graphite having structure other than diamond as being identified by Raman spectrum method, while featuring extremely high electric resistance and cnsummation degree. However, when applying any method generating non-polar discharge of microwaves inside of the reactive tube which vertically penetrates a conventional waveguide tube, due to short wavelength of microwaves, if a reaction tube has a diameter longer than the wavelength of microwaves is made available, since this system cannot perfectly seal microwaves and causes microwaves to leak out of the reaction tube, the diameter of the reaction tube is constrained by the wavelength of microwaves, thus making it difficult for the reaction tube to provide wide coating zone and resulting in the difficulty to implement mass production. More particularly, Japanese industries normally use 915 MHz and 2,350 MHz of industrial frequencies. These frequencies constrain the diameter of the reaction tube within a maximum of 120 mm and 50 mm, respectively. Consequently, these diameters are not sufficient for generating a large-dimension coating zone durable for implementing mass production on the industrial basis. On the other hand, when applying RF plasma CVD method, in order to generate extremely consummate diamond, the system needs to generate extremely intensified plasma. Only the induction-coupling type RF power-supply source is actually made available for exciting plasma. It should be noted that capacity-coupling type RF power-supply source cannot synthesize crystalline diamond except for amorphous diamond.

In other words, in order to generate a large-dimension coating zone by applying RF induction-coupling type power-supply source, the system should be provided with an extremely large-capacity RF power-supply source which in turn involves much difficulty in the industrial application.

On the other hand, since the prior art cited in (4) Japanese Patent Laid-Open No. 60-221395 (1985) proposing the electron-shower-applied CVD method uses electron shower, the amount of power to be supplied between filaments and the substrate is limited, and thus, it cannot generate as much the film growth rate as that is normally achieved by the diamond synthesis method related to the invention. Furthermore, since it is essential for this prior art to apply shower by means of electrons, while the electron shower does not reach the substrate itself under presence of high atmospheric pressure, the system related to this prior art cannot actually generate diamond film by applying 50 through 500 Torr of extremely high pressure proposed by the preferred embodiment of the present invention.

In principle, due to diversified configurations and application of a plurality of thermoelectron radiating materials, and in addition, as a result of proper arrangement of these materials and the substrate, the thermoelectron radi-ating material CVD method can process a large number of diamond and implement coating of a large area as well. However, this prior art still has problems to solve, in which more amount of carbon other than diamond is present in the synthesized diamond than the amount of carbon present in the diamond synthesized by the microwave plasma CVD method, thus eventually degrading the degree of the consummation of diamond itself, while also causing electric resistance to lower.

## SUMMARY OF THE INVENTION

In the light of those problems mentioned above, after judging that the thermoelectron radiating material CVD was quite advantageous for implementing mass production of diamond film, inventors followed up efforts for establishing a method of improving the quality of diamond film.

Inventors considered that plasma advantageously functioned for generating excellent quality of diamond film by applying the microwave plasma CVD method, in which raw-material gas significantly decomposed and activated itself, while this method could apply a variety of concentrations and kinds of radicals and ions having relationship with reaction. As a result, inventors considered that these conditions were advantageous for synthesizing extremely consummate diamond film, and inventors eventually detected useful application of plasma in order to securely promote the activation degree of raw-material gas based on the thermoelectron radiating material CVD method.

More particularly, the invention relates to a method of synthesizing diamond, which is substantially the method of synthesizing diamond by applying low-pressurized vapor phase for causing diamond to precipitate itself on the surface of substrate heated to 600°C through 1,200°C by activating raw-material gas which is composed of the mixture of hydrogen with solid carbon, or hydrocarbon, or hydrocarbon containing O and N in the bonded radical, or carbon tetrachloride, wherein the method is comprised of the sequential steps of; activating the above raw-material gas by applying thermoelectron radiating material heated to a minimum of 1,600°C, providing potential by connecting positive electrode to grid disposed between thermoelectron radiating material which is provided with negative electrode and the substrate to be treated with coating process by applying DC power-supply source; extracting thermoelectrons for generating plasma; providing potential by connecting the positive and negative electrodes to the grid and the substrate by applying another DC power-supply source; generating plasma by holding the potential of the substrate negative in order that the effect of the activation generated by thermoelectron radiating material and the generated DC plasma can jointly be applied; and maintaining the pressure inside of the reactor generating the DC plasma to be a minimum of 10 Torr and a maximum of 400 Torr, respectively.

By applying negative potential to the substrate, inventors arranged the system to simultaneously generate DC bias effect which is conventionally made available for ion- plating process. Based on knowledges of the inventors, in order to securely generate extremely consummate diamond, extremely pressurized gas ranging from 10 Torr to several hundred Torr was compulsorily needed for generating the designed plasma. It should be noted that extremely consummate diamond film denotes the one having a maximum of 2 microns of mean particle size, while the diamond film is mainly composed of surface (111) having a minimum of $10^{10}$ $\Omega \cdot$cm of electric resistance. Although the diamond film may also be provided with surfaces (100) or (110) as well, due to convenience of tools, diamond surface should desirably be provided with surface (111). It should also be noted that electric resistance normally indicates a certain amount of residual carbon. In other words, the higher the electric resistance, the less is the amount of residual carbon such as amorphous carbon and graphite.

## BRIEF DESCRIPTION OF THE DRAWINGS

The invention will be better understood from the following detailed description and the accompanying drawings which are given by way of illustration only, and thus are not limitative of the invention and wherein:

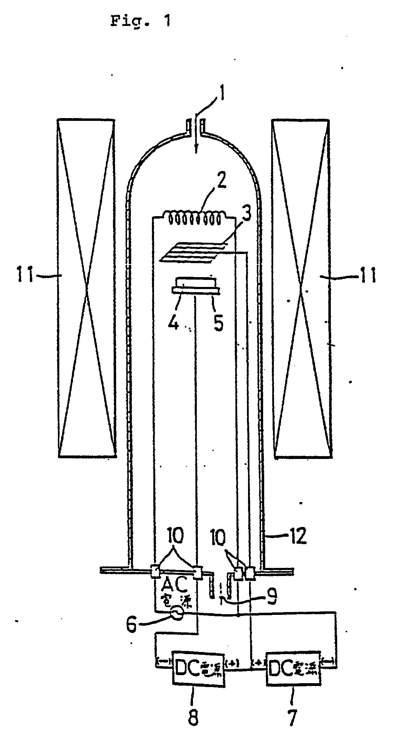

FIG. 1 is the front view of a preferred embodiment of the apparatus for implementing the method of synthesizing diamond related to the invention, which is comprised of the following constituents denoted

3

EP 0 254 312 B1

by respective reference numerals shown below;
1---Raw-material gas inlet
2---W-filament of thermoelectron radiating material
3---Grid4---Substrate5---Substrate holding base
6---AC power-supply source for heating thermoelectron radiating material
7---DC power-supply source generating plasma between thermoelectron radiating material and grid
8---DC power-supply source providing the substrate with negative potential
9---Vacuum exhaust outlet10---Insulation seal
11---External furnace
12---Transparent quartz reaction tube and

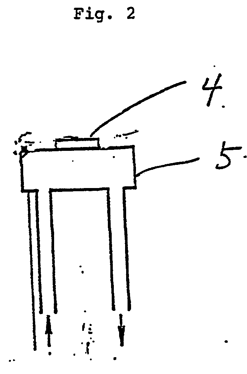

FIG. 2 is the constitution of the substrate holding base improved from the one used for the preferred embodiment of the invention, which is provided with cooling device. Arrowed directions respectively denote the flow path of refrigerant. The cooling device properly adjusts temperature of the substrate by allowing fluid like water and/or gas to flow through it. It is also possible for the improved substrate holding base to more precisely control temperature by internally providing a temperature-measuring instrument in part of the substrate or the substrate holding base.

DESCRIPTION OF THE PREFERRED EMBODIMENTS

FIG. 1 is the simplified block diagram of a preferred embodiment of the apparatus for implementing the method of synthesizing diamond related to the invention. First, $CH_4$ and $H_2$ mixed gas are led into quartz-made reaction tube 12 via raw-material gas inlet 1, and then, the mixed gas is thermally activated by thermoelectron radiating material 2 heated to more than 1,600°C. At the same time, the apparatus causes negative electrode and positive electrode to respectively be connected to thermoelectron radiating material 2 and grid 3 by applying DC power-supply source 7 so that plasma can be generated between thermoelectron radiating material which has extracted thermoelectrons from thermoelectron radiating material 2 and the grid 3. The substrate 4 is then held in the negative potential so that the positive ion can positively be drawn onto the surface of the substrate 4 by allowing the negative electrode to be connected to the substrate 4 on the holding base 5. While executing these processes, the system uses extremely pressurized gas ranging from a minimum of 10 Torr to a maximum of 400 Torr. The apparatus shown in FIG. 1 is provided with AC power-supply source 6 for heating thermoelectron radiating material, vacuum exhaust outlet 9, insulation seal 10, and external furnace 11, respectively.

The invention provides four features which are summarized below.

(1) By jointly applying DC plasma together with pyrolysis and activation of raw-material gas generated by extremely-heated thermoelectron radiating material, degree of the activation of raw-material gas is promoted and causes kinds of ion to be generated that otherwise cannot be generated merely by means of pyrolysis.

(2) Negative potential is applied to the substrate to allow positive ion to be drawn onto the substrate surface positively.

(3) By disposing grid between thermoelectron radiating material and substrate, the apparatus generates plasma between thermoelectron radiating material and the grid and also between the grid and the substrate, respectively.

(4) The apparatus related to the invention generates plasma by applying extremely high pressure ranging from a minimum of 10 Torr to a maximum of 400 Torr. Normally, plasma cannot stably be generated or maintained merely by applying DC power-supply source under presence of such a high pressure mentioned above.

In order to stably generate and maintain plasma by applying such an extremely high pressure ranging from a minimum of 10 Torr to a maximum of 400 Torr, it is essential for the system to extract thermoelectrons from thermoelectron radiating material. When feeding negative potential to the substrate, if the negative electrode and the positive electrode were respectively connected to the substrate and thermoelectron radiating material by applying DC power-supply source, thermoelectrons cannot be extracted from thermoelectron radiating material but conversely thermoelectrons will be set back, and as a result, no plasma can be generated under presence of such a high pressure mentioned above.

Now, the apparatus related to the invention disposes a grid between thermoelectron radiating material and the substrate so that plasma can be generated between these members by allowing thermoelectrons to be extracted from thermoelectron radiating material after connecting the negative electrode to thermoelectron radiating material and the positive electrode to the grid by applying DC power-supply source. Furthermore, the apparatus causes the already-generated positive ion to be drawn onto the substrate and generates plasma by respectively connecting the positive electrode and the negative electrode to the grid and the substrate by applying another DC power-supply source.

It is considered that the preferred embodiment of the diamond-synthesizing method and apparatus related to the invention can securely generate such an extremely consummate diamond based on the

4

reasons explained below.

The invention allows generation of DC plasma in addition to the pyrolysis and the activation of raw-material gas done by thermoelectron radiating material in order that the degree of activation can securely be promoted. This in turn intensifies energy of the activated gas and causes the gas volume remaining in the activated state to increase itself, where the activated gas includes hydrogen radical capable of selectively eliminating carbon (other than diamond) precipitating itself together with diamond and/or methyl radical having $SP^3$ mixed track needed for generating diamond. In addition, since the life of the activated gas is durable, graphite and/or amorphous carbon having structure other than diamond can be prevented from precipitating itself, thus eventually allowing such extremely consummate diamond film to be generated securely.

Furthermore, inventors detected in surprise that the bonded strength between diamond film and the substrate has significantly been promoted by feeding negative potential with DC power-supply source. Although the reason for this effect is not yet clear, it is probable that the positive ion of the raw-material gas ionized by plasma generated between thermoelectron radiating material and grid has preferentially been drawn onto the surface of the substrate.

Furthermore, the diamond synthesis method related to the invention proved to have generated significantly fine composition of the diamond film which was formed on the surface of the substrate. It is probable that both the impact of ion against the surface of the substrate and the plasma generated on the surface of the substrate advantageously affected the degree of activation of the activated ingredients, concentration, and the life of these activated ingredients as well, thus eventually promoting the density of the diamond nucleus being generated.

It is obvious that execution of these processes under presence of high pressure advantageously promoted the density of the generated diamond nucleus.

The invention securely provides an extremely consummate diamond film which is free from such carbon matter having shape other than diamond and features a maximum of 1 micron of fine constitution of the diamond film even after being exposed to a minimum of 1,000°C of high temperature by generating extremely intensified bonding strength against the substrate.

The method of synthesizing diamond related to the invention allows the use of carbon ingredients, for example, such as solid carbon, or hydrocarbon, or hydrocarbon containing O and N in the bonded radical, or carbon tetrachloride. It is possible for the diamond synthesis method related to the invention to effectively use raw-material gas composed of the mixture of at least more than one kind of those carbon ingredients and hydrogen. When solid carbon is made available for carbon source, it is desirable for the system to use carbon for making up thermoelectron radiating material.

Of the raw-material gas present in the reactor, there is a specific proportional number of carbon atoms against the number of hydrogen atoms, i.e., by a minimum of 0.01% and a maximum of 20%. If the proportional rate of carbon atoms present in the raw-material gas is less than 0.01%, diamond film will grow itself at an extremely slow rate, which is not durable enough for actual use. Conversely, if the proportional rate of carbon atoms in the raw-material gas exceeds 20%, compared to diamond, a greater amount of carbon having structure other than diamond will precipitate itself, thus eventually inhibiting formation of diamond film.

In addition to those gas ingredients delivered to the reactor, Ar, Kr, Xe, Rn, and $N_2$, which are respectively independent of the reaction may also be used in mixture with those gas ingredients mentioned above. Each of these can effectively be used for cooling down temperature of the substrate owing to low thermal conductivity, and yet, each properly adjusts the strength of plasma as another phase of advantage.

It is essential for the thermoelectron radiating material and the grid material to provide low-vapor pressure under presence of high temperature and have high melting point as well.

In particular, it is essential for thermoelectron radiating material to be superb in the capacity of releasing thermoelectrons. Consequently, it is desirable that both the thermoelectron radiating material and the grid be made from those materials having high melting point like tungsten (W), tantalum (Ta), or molybdenum(Mo), or $LaB_6$, or graphite, for example. Thermoelectron radiating material should be used only after being heated to a minimum of 1,600°C of ultra-high temperature. If temperature goes down from 1,600°C, graphite and amorphous carbon will dominantly precipitate themselves. Unless the surface of the substrate bears a minimum of 600°C and a maximum of 1,200°C, diamond does not precipitate at all.

Reactor should internally be provided with a minimum of 10 Torr and a maximum of 400 Torr of pressure, preferably the internal pressure should a minimum of 50 Torr and a maximum of 300 Torr. If the pressure inside of the reactor exceeds 400 Torr, it is difficult for the apparatus related to the invention to stably maintain plasma between the grid and the substrate. Conversely, if the pressure inside of the reactor is lower than 10 Torr, evaporation speed will significantly lower, thus generating unwanted results.

The invention features the capability of stably generating and maintaining plasma under presence of high pressure, which cannot actually be realized by any conventional system that merely uses DC power-supply source. This is because the expansion of gas pressure effectively promotes the density of the generated diamond nucleus.

The intensity of plasma generated between thermoelectron radiating material and the grid is dependent on the gas atmosphere, configuration of thermoelectron radiating material and grid, temperature of thermoelectron radiating material, arrangement of thermoelectron radiating material and grid, and the power output from DC power-supply source. Since the plasma radiation is observed in the position close to the grid, it is desirable for the apparatus to properly control the plasma-generating condition by applying DC power-supply source which is delivered per unit area of the grid.

When embodying the invention, it is desirable for the apparatus to feed a minimum of 10 W/cm² of DC power between the thermoelectron radiating material and the grid. If the apparatus receives less than 10 W/cm² of DC power, the apparatus cannot stably generate and maintain plasma between the grid and the substrate. Furthermore, the intensity of plasma generated between the grid and the substrate is dependent on the intensity of plasma generated between thermoelectron radiating material and grid, gas atmosphere, configuration of the grid, substrate, and the substrate holding base, arrangement of the grid and the substrate, and the power output from DC power-supply source. Like the above case, since plasma is generated in the position close to the grid and the surface of the substrate facing the grid, it is desirable for the apparatus to properly control the plasma by applying DC power-supply source delivered per unit area of the substrate surface to be coated.

The apparatus related to the invention should desirably feed a minimum of 5 W/cm² and a maximum of 200 W/cm² of DC power between the thermoelectron radiating material and the grid. If less than 5 W/cm² of DC power is delivered, the apparatus will not be able to stably generate and maintain plasma between the grid and the substrate. Conversely, if more than 200 W/cm² of DC power is delivered, the plasma etching effect will be magnified, thus extremely slowing down the diamond precipitation speed.

Temperature on the surface of the substrate is dependent on the temperature of thermoelectron radiating material, arrangement and configuration of thermoelectron radiating material, grid, and the substrate, DC power being delivered between the thermoelectron radiating material and the grid, DC power being delivered between the grid and the substrate, gas atmosphere, and temperature of the external furnace, etc. The optimum effect of the invention is generated by properly selecting specific conditions from those mentioned above.

It may be necessary for the diamond synthesizing apparatus related to the invention to execute operations for cooling down temperature of the substrate holding base and the wall of the reactor in order to precisely constrain temperature on the surface of the substrate within an adequate range. Control of temperature on the surface of substrate is extremely important for the apparatus related to the invention in order to correctly control stress which remains on the diamond film.

More particularly, there is the difference in the thermal expansion coefficient between diamond and the substrate, and thus, since there is a difference between the diamond synthesizing temperature and the temperature actually being used, stress remains in the diamond film. If the remaining stress is too strong, diamond film will be stripped off from the substrate. The greater the thickness of the diamond film, the greater is the possibility of causing diamond film to be stripped off from the substrate. However, more satisfactory diamond film will be generated if more than a specific amount of stress remains in the diamond film. The reason for this has not yet been clarified.

## DESCRIPTION OF THE PREFERRED EMBODIMENTS

Referring now more particularly to the accompanying drawings, preferred embodiments of the method and the apparatus for synthesizing diamond related to the invention are described below.

< The First Preferred Embodiment >

Using substrate made from molybdenum(Mo) plate having 10 mm × 10 mm × 1 mm of dimension and the surface which is ground with #5000 diamond grinding particles while employing the diamond synthesizing apparatus shown in FIG. 1, inventors experimentally carried out diamond coating operations. First, inventors decompressed pneumatic pressure. from the reactor to a maximum of $10^{-3}$ Torr. Then, inventors fed gas which was composed of a mixture of $CH_4$ and $H_2$ at the 1/100th rate into the reactor at 100 ml/min. of flow rate. While maintaining a specific pressure inside of the reactor and using tungsten(W)-made filament which substantially made up thermoelectron radiating material, inventors once heated the compound gas to more than 2,000°C in order that temperature on the surface of the substrate could be adjusted to 920°C. Inventors arranged the distance between tungsten filament and grid made from tungsten to be 5 mm and also the distance between tungsten filament and molybdenum-made substrate of the grid to be 4 mm, respectively. Next, using DC power-supply source, inventors fed power by connecting the filament to the negative electrode and the grid to the positive electrode. Then, using another DC power-supply source, inventors fed power by connecting the filament to the negative electrode and the grid to the positive electrode, and then, inventors adjusted power output from these two DC power-supply sources flowing through filaments in order that temperature on the surface of the substrate could precisely be stabilized at 920°C. Inventors set 4 hours of the diamond coating time. Table 1 represents the coating conditions and characteristic of the coated film. Depending on the coating conditions, inventors adjusted temperature on the surface of the substrate by cooling down temperature borne by the substrate holding base.

For comparative evaluation, using the same molybdenum-made substrate and the 2.45 GHz microwave plasma CVD apparatus, inventors fed gas which was composed of a mixture of $CH_4$ and $H_2$ at the 1/100th rate into the reactor at 200 ml/min. of flow rate. As shown in Table 1, using 40 Torr of pressure, 250W of microwave power, and 910°C of temperature on the surface of the substrate, inventors carried out a coating process for 4 hours consecutively. Table 1 also represents characteristic of the coated film detected from the comparative evaluation. In order to generate ohmic contact for determining electric resistance of diamond film, using ion-plating apparatus, inventors prepared an electrode by coating titanium (Ti) and gold (Au) for making up the first and second layers on the diamond film. Using this electrode and another electrode made from molybdenum substrate plate, inventors measured V-I characteristic between these electrodes for determining electric resistance.

Table 1

| No. | Pressure (Torr) | Power supplied between filament and grid (W) | Power supplied between grid and substrate (W) | Electric resistance (Ω·cm) | Crystalline particle size (μm) | Remarks |
|---|---|---|---|---|---|---|
| 1 | 5 | 40 | 40 | - | - | Film was not generated completely. |
| 2 | 10 | 5 | - | - | - | No plasma was generated between the grid and the substrate. |
| 3 | " | 40 | 40 | $10^{11}$–$10^{12}$ | 1 -2 | |
| 4 | 50 | " | " | $10^{12}$–$10^{13}$ | 0.7 -0.5 | |
| 5 | 100 | 10 | 60 | $10^{11}$–$10^{12}$ | 0.7 -1.0 | |
| 6 | " | 40 | 20 | $10^{12}$–$10^{13}$ | 0.4 -0.7 | |
| 7 | " | " | 40 | " | 0.1 -0.3 | |
| 8 | " | 80 | 20 | " | 0.3 -0.5 | |
| 9 | " | " | 40 | " | 0.1 -0.3 | |
| 10 | " | " | 60 | " | 0.05-0.2 | |
| 11 | 200 | 40 | 40 | " | " | |
| 12 | 300 | 120 | " | " | " | |
| 13 | 450 | 200 | - | - | - | Plasma did not stabilize itself between the filament and the grid. |
| 14 | 100 | 0 | 0 | $10^4$ –$10^5$ | 3 -5 | |
| 15 | 40 | Microwave power 250W | - | $10^9$ –$10^{10}$ | 1.5 -2.5 | |

Experiments cited in Table 1 proved that satisfactory diamond film was uniformly generated except for experiments Nos. 1, 2, and 13 which were consequently deleted from the scope of the claims of the invention. Compared to No. 14 experiment which dispensed with plasma, other experiments significantly promoted electric resistance of the diamond film. Table 1 also represents that the experiments done for the first preferred embodiment of the invention satisfactorily generated superb diamond film featuring quite higher electric resistance than that of the diamond film generated by No. 15 microwave plasma CVD method.

After executing Raman spectrum analysis, inventors observed the presence of amorphous carbon in the diamond film generated by No. 14 experiment. Conversely, inventors confirmed that no amorphous carbon was present in those diamond films generated from experiments which applied plasma. Inventors confirmed from comparative evaluations of experiments Nos. 3, 4, 7, and 11 that particles of diamond film became finer relative to the intensified degree of plasma. Likewise, inventors also confirmed that crystalline particles of diamond became finer when plasma strength was intensified. It was extremely difficult for the microwave plasma CVD method to securely generate fine particle composition like the one mentioned above under presence of high substrate temperature.

< The Second Preferred Embodiment >

The second preferred embodiment of the method and apparatus for synthesizing diamond related to the invention is described below.

By implementing the second preferred embodiment of the invention, extremely consummate diamond surpassing that is achieved by the microwave plasma CVD method featuring a maximum of 1 micron of fine particle size and unsurpassed strength of bonding with the substrate is securely generated even under exposure to a minimum of 1,000°C of high temperature. In addition, it is possible for the second preferred embodiment of the invention to execute processing of a plurality of substrates and coating process over a wide area by applying a plurality of thermoelectron radiating materials.

Inventors experimentally coated a molybdenum substrate having 200 mm x 150 mm x 10 mm of dimension ground with #600 diamond whetstone by applying 21 units of thermoelectron radiating materials which were also made available for implementing the first preferred embodiment. In order to precisely adjust temperature of each thermoelectron radiating material, heating power sources were independently provided so that temperature of each thermoelectron radiating material could independently be controlled. However, in order to connect DC power-supply source, one-side of the electrodes were commonly connected to each other. According to the dimension of the substrate, inventors arranged the size of the grid disposed between the thermoelectron radiating material and the substrate to be 220 mm x 180 mm.

First, inventors decompressed pneumatic pressure from the reactor to a maximum of $10^{-3}$ Torr. Then, inventors fed gas which was composed of a mixture of $CH_4$ and $H_2$ at the 1/100th rate into the reactor at 200 ml/min. of flow rate so that the pressure inside of the reactor could be held at 90 Torr. Inventors once heated tungsten filament made available for thermoelectron radiating material to a minimum of 2,000°C in order that temperature on the surface of the substrate could be adjusted in a range from 980°C to a maximum of 1,010°C.

Next, using DC power-supply source, inventors fed 40W of power per unit area of grid by connecting tungsten filament and the grid to the negative and positive electrodes before eventually generating plasma between the filament and the grid. Next, using another DC power-supply source, inventors fed 20W of power per unit area of the grid by connecting the grid and the substrate to the positive and negative electrodes before eventually allowing plasma to be generated on the surface of the substrate. Since the supplied DC power could heat up temperature on the surface of the substrate, inventors decreased the amount of DC current flowing through the filament so that temperature of the filament could be lowered. Inventors also cooled the substrate holding base with water so that temperature on the surface of the substrate could be adjusted to a range from 980°C to a maximum of 1,010°C.

Now, as a result of coating process done for 4 hours consecutively, the second preferred embodiment of the invention successfully generated diamond film having 8 μm in average of thickness with a maximum of 10% of unevenness. Each crystalline particle had an extremely fine size ranging from 0.3 micron to a maximum of 0.8 micron. Evaluation of electric resistance resulted in quite satisfactory values ranging from $10^{11}$ to a maximum of $10^{12}$ Ω•cm.

Consequently, inventors confirmed that the second preferred embodiment of the invention could extensively and uniformly coat the substrate with extremely consummate diamond crystals featuring extremely fine constitution.

< The Third Preferred Embodiment >

For implementing the third preferred embodiment of the invention, inventors employed the substrate made from SPG 422 type ISO K-10 cemented carbide. Using the same apparatus as that was employed for the first preferred embodiment, inventors executed coating of substrate with diamond film. Inventors arranged the distance between the filament and the grid to be 5 mm and the distance between the grid and the upper surface of the insert to be 4 mm, respectively.

First, inventors decompressed the pneumatic pressure from the reactor to a maximum of $10^{-3}$ Torr. Then, inventors fed gas which was composed of a mixture of $CH_4$ and $H_2$ at the 1/100th rate into the reactor at 100 m/min. of flow rate. While maintaining the pressure inside of the reactor at 90 Torr, inventors once heated tungsten filament to a maximum of 2,000°C in order that temperature on the surface of the substrate could be adjusted to 950°C.

Next, using DC power-supply source, inventors connected the filament and the grid to the negative and positive electrodes for generating potential before eventually generating plasma. In addition, using another DC power-supply source, inventors connected the grid and the substrate to the positive and negative electrodes for generating potential. Then, inventors adjusted amount of DC current flowing through the filament and the amount of current output of these two DC power-supply sources in order that temperature on the surface of the substrate could be held exactly at 950°C. Inventors eventually carried out coating processes for 3 hours consecutively based on those conditions shown in Table 2.

## Table 2

| No. | Pressure (Torr) | Power supplied between filament and grid (W) | Power supplied between grid and substrate (W) |
|-----|-----------------|----------------------------------------------|-----------------------------------------------|
| 16  | 90              | 30                                           | 30                                            |
| 17  | "               | "                                            | 60                                            |
| 18  | "               | "                                            | 90                                            |
| 19  | "               | 60                                           | 30                                            |
| 20  | "               | "                                            | 60                                            |
| 21  | "               | "                                            | 90                                            |

After completing the coating processes based on those conditions shown in Table 2, satisfactory diamond film was uniformly generated. For comparison with those inserts used for the experiments, inventors adjusted temperature on the surface of the substrate at 950°C by adjusting the amount of DC current flowing through filament. Substrate A was coated for 3 hours by conventional thermoelectron radiating CVD method and surface temperature, pressure, composition of raw material gas was same as mentioned above. Substrate B was not coated. Using these inserts, inventors carried out cutting tests based on conditions shown below.

Objective material: Aluminum-25% silicon
Cutting speed: 500 meters per minute
Material feed rate: 0.1 mm/rev.
Cutting depth: 0.5 mm
Holder: FR 11R - 44A

As a result of the above test, substrate B which was not yet treated with coating process generated 0.40 mm of Frank wear after the cutting process which lasted for 15 seconds, whereas substrate A which was complete with the coating process generated 0.16 mm of Frank wear after the cutting process which lasted for 20 minutes. Compared to these, after the cutting process which lasted for 30 minutes, those specimens made available for implementing the third preferred embodiment of the invention respectively generated less amount of Frank wear as shown below.

Specimen No. 16 0.12 mm; Specimen No. 17 0.10 mm
Specimen No. 18 0.07 mm; Specimen No. 19 0.10 mm
Specimen No. 20 0.07 mm; Specimen No. 21 0.06 mm

These results proved that the third preferred embodiment of the invention securely generated significantly advantageous effect.

The fourth preferred embodiment

By additionally installing the cooling device shown in Fig. 2 to the apparatus shown in Fig. 1 and by applying those conditions shown in Table 3 as well as those methods explained in the preceding section related to the first preferred embodiment, inventors executed experimental diamond-film coating for two hours. The experiment successfully generated extremely consummate diamond film having the thickness shown in Table 3.

Table 3

| Classi-fication | No. | Carbon Source | Other Gas | Carbon Source/ Other Gas | Thermoelectron Radiating Material | | Temp. on Substrate | Substrate Material | Pressure (Torr) |
|---|---|---|---|---|---|---|---|---|---|
| | | | | | Material | Temp. (°C) | | | |
| Preferred Embodiments | 22 | $CH_4$ | $H_2$ | 0.5/100 | $\overline{W}$ | 2000 | 800 | $\overline{W}C$-5% Co | 50 |
| | 23 | $CH_3COCH_3$ | $H_2$ | 1/100 | Ta | 2050 | 950 | $Si_3N_4$ | 150 |
| | 24 | $(CH_3)_2CN$ | $H_2$ | 2/100 | $\overline{W}$ | 2150 | 900 | $\overline{W}C$-5% Co | 80 |
| | 25 | Solid Object C | $H_2$ | --- | C | 2300 | 1050 | $\overline{W}$ | 100 |
| | 26 | $CH_4$ | $85H_2$-$15Ar$ | 2/100 | $\overline{W}$ | 2150 | 900 | $\overline{W}C$-5% Co | 150 |
| Comparative Examples | 27 | $CH_4$ | $H_2$ | 0.5/100 | $\overline{W}$ | 2000 | 550 | $\overline{W}C$-5% Co | 50 |

| Classi-fication | No. | Film Thickness (μm) | Power between filament and grid ($\overline{W}$) | Power between grid and substrate ($\overline{W}$) | Results of cutting test | |
|---|---|---|---|---|---|---|
| Preferred Embodiments | 22 | 0.8 | 40 | 30 | △ | |
| | 23 | 25 | 60 | 40 | ◉ | |
| | 24 | 20 | 50 | 50 | ○ | |
| | 25 | 4 | 40 | 40 | ◉ | |
| | 26 | 3 | 25 | 20 | ○ | |
| Comparative Examples | 27 | -- | 60 | 30 | x | |

EP 0 254 312 B1

Next, by applying the identical conditions and by adjusting the coating time, inventors processed cutting tools having the configuration No. SPG-422 in order that the thickness of diamond film could exactly become 6 μm. Finally, inventors assessed the conditions of the processed cutting tools by executing cutting tests. Conditions empleyed for executing the cutting tests are shown below.

Objective material:Aluminum - 8% silicon
Cutting speed:1,800 meters per minute
Material feed rate:0.1 mm/rev.
Cutting depth:0.2 mm
Duration of cutting tests:2 hours
    Note that symbols

<p style="text-align:center">◎ , ○ , ▲ ,</p>

and x shown in Table 3 respectively denote the grade order of worn-out amount between those tools which were coated with diamond film and those which are not coated with it. The least amount of wear is denoted by the double circle, followed by the single circle, the triangle, and x, respectively. Symbol x denotes the amount of wear which is equivalent to that is not coated with diamond film.

Test No. 27 merely generated amorphous carbon.

When executing the cutting tests in accordance with those conditions shown in Table 3, inventors properly adjusted temperature of substrates by applying the cooling device shown in Fig. 2.

< Industrial Applicability >

As is clear from the foregoing description, based on the thermoelectron radiating material CVD method, the preferred embodiments of the invention respectively activate raw-material compound gas by applying thermoelectron radiating material being heated to a minimum of 1,600°C, and then, using a DC power-supply source, potential is generated for the diamond synthesizing apparatus by connecting thermoelectron radiating material to the negative electrode and the grid to the positive electrode, in which the grid is disposed between the thermoelectron radiating material and the substrate subject to coating with diamond film, thus allowing thermoelectrons to be extracted from this material so that plasma can eventually be generated. The apparatus related to the invention also uses another DC power-supply source for generating potential by connecting the grid and the substrate to the positive and negative electrodes for generating plasma while holding the substrate potential negative. The apparatus jointly uses activation generated by thermoelectron radiating material and the other activation caused by generation of DC plasma, and yet, by properly controlling pressure inside of the reactor to a minimum of 10 Torr and a maximum of 400 Torr for causing plasma to be generated, the apparatus securely generates extremely consummate diamond which is significantly better in quality than that which is normally generated by the thermoelectron radiating material CVD method. Furthermore, since the apparatus related to the invention provides diamond with significantly satisfactory electric resistance which is incomparable to that which is normally generated by the microwave plasma CVD method, the diamond which is synthesized by the method and the apparatus related to the invention is usefully applicable to a wide variety of electronic materials requiring extremely satisfactory insulation effect such as heat-radiating printed wiring boards and diamond semiconductors for example.

Furthermore, since the method and the apparatus related to the invention securely provide fine-particle-size diamond film even under the presence of high temperature above 1000°C with extremely strong bonding effect against the substrate, the method and the apparatus for synthesizing diamond related to the invention securely and significantly improve the productivity by effectively being applied to those uses which effectively utilize mechanical characteristic of diamond such as cutting tools and wear-resistant parts for example.

**Claims**

1. A method of synthesizing diamond, which is substantially a method of synthesizing diamond by applying low-pressurized vapor phase, wherein said method uses carbon source such as solid carbon, or hydrocarbon, or hydrocarbon containing O and N in the bonded radical, or carbon tetrachloride, where said method causes raw-material compound gas composed of a mixture of said carbon ingredient and hydrogen to be activated for eventually precipitating diamond on the surface of substrate (4) being heated to a minimum of 600°C through a maximum of 1,200°C, wherein comprising steps and processes of:
causing thermoelectron radiating material (2) heated to a minimum of 1,600°C to activate said compound gas;
generating potential by connecting said thermoelectron radiating material (2) to negative electrode and grid (3) disposed between said thermoelectron radiating material (2) and substrate (4) subject to coating to positive electrode by applying a DC power-supply source;

extracting thermoelectrons from said thermoelectron radiating material (2) for generating plasma;

generating potential by connecting grid (3) to positive electrode and substrate (4) to negative electrode by applying another DC power-supply source (7) for generating plasma while maintaining potential of said substrate (4) negative;

jointly applying effect of activation generated by thermoelectron radiating material (2) and another activation caused by generation of DC plasma; and

controlling pressure inside of plasma-generating reactor to be a minimum of 10 Torr and a maximum of 400 Torr, respectively.

2. The method of synthesizing diamond defined in Claim 1, wherein the proportional number of carbon atom against the number of hydrogen atom of raw-material compound gas in said reactor is a minimum of 0.01% and a maximum of 20%.

3. The method of synthesizing diamond defined in claim 1, wherein said thermoelectron radiating material (2) is substantially comprised of any of those elements including tungsten (W), tantalum (Ta), molybdenum (Mo), or LaB$_6$, or graphite.

4. The method of synthesizing diamond defined in claim 1, wherein a minimum of 10 W/cm$^2$ of DC power is supplied between said thermoelectron radiating material (2) and grid (3).

5. The method of synthesizing diamond defined in claim 1, wherein 5 through 200 W/cm$^2$ of DC power is supplied between said grid (3) and substrate (4).

6. The method of synthesizing diamond defined in Claim 1, wherein temperature on the surface of said substrate (4) is adjustable as required.

**Patentansprüche**

1. Verfahren zur Synthese von Diamant, das im wesentlichen ein Verfahren zur Synthese von Diamant darstellt, bei dem man eine Niederdruckgasphase verwendet, wobei dieses Verfahren eine Kohlenstoffquelle, wie festen Kohlenstoff oder Kohlenwasserstoff oder Kohlenwasserstoff, der Sauerstoff und Stickstoff in dem gebundenen Radikal enthält, oder Kohlenstofftetrachlorid, verwendet, wobei dieses Verfahren bewirkt, dass das Ausgangsverbindungsgas, das sich aus einer Mischung der besagten Kohlenstoffkomponente und Wasserstoff zusammensetzt, für die schliessliche Fällung von Diamant auf der Oberfläche des Substrates (4), das bis zu einem Minimum von 600°C und bis zu einem Maximum von 1200°C erhitzt ist, aktiviert wird, wobei die folgenden Schritte und Prozesse umfasst sind:

Erhitzen des thermoelektronischen Strahlungsmaterials (2) auf ein Minimum von 1600°C, um das Verbindungsgas zu aktivieren;

Erzeugen einer Spannung durch Verbinden des thermoelektronischen Strahlungsmaterials (2) mit der negativen Elektrode und des Gitters (3), das zwischen dem thermoelektronischen Strahlungsmaterial (2) und dem Substrat (4), das Gegenstand für die Beschichtung ist, angeordnet ist, mit der positiven Elektrode über eine DC-Stromversorgungsquelle;

Extrahieren von Thermoelektronen aus dem thermoelektronischen Strahlungsmaterial (2) zur Erzeugung eines Plasmas;

Erzeugen einer Spannung durch Verbinden des Gitters (3) mit der positiven Elektrode und des Substrates (4) mit der negativen Elektrode unter Verwendung einer anderen DC-Stromversorgungsquelle (7) zur Erzeugung des Plasmas, während man das Potential des Substrates (4) negativ hält;

gemeinsame Anwendung der Aktivierungswirkung, die durch das thermoelektronische Strahlungsmaterial (2) bewirkt ist, und der anderen Aktivierung, die durch Erzeugung des DC-Plasmas bedingt ist; und

Regeln des Drucks innerhalb des plasmaerzeugenden Reaktors auf ein Minimum von 10 Torr und auf ein Maximum von 400 Torr.

2. Verfahren zur Synthese von Diamant nach Anspruch 1, wobei die Verhältniszahl des Kohlenstoffatoms gegenüber der Zahl des Wasserstoffatoms des Ausgangsverbindungsgases in dem Reaktor einen Minimumwert von 0, 01 % und einen Maximumwert von 20% besitzt.

3. Verfahren zur Herstellung von Diamant nach Anspruch 1, wobei das thermoelektronische Strahlungsmaterial (2) sich im wesentlichen aus einem der Elemente Wolfram (W), Tantal (Ta), Molybdän (Mo) oder LaB$_6$ oder Graphit zusammensetzt.

4. Verfahren zur Herstellung von Diamant nach Anspruch 1, wobei man ein Minimum von 10 W/cm$^2$ an DC-Leistung zwischen dem thermoelektronischen Strahlungsmaterial (2) und dem Gitter (3) zuführt.

5. Verfahren zur Herstellung von Diamant nach Anspruch 1, wobei man 5 bis 200 W/cm$^2$ an DC-Leistung zwischen dem Gitter (3) und dem Substrat (4) zuführt.

6. Verfahren zur Herstellung von Diamant nach Anspruch 1, wobei man die Temperatur auf der Oberfläche des Substrates (4) wie erforderlich anpasst.

**Revendications**

1. Procédé de synthèse du diamant, qui est sensiblement un procédé de synthèse du diamant par application d'une phase gazeuse mise sous une faible pression, ledit procédé utilisant une source de carbone telle que du carbone solide, ou un hydrocarbure, ou un hydrocarbure contenant O et N dans le radical lié, ou le tétrachlorure de carbone, ledit procédé amenant le gaz brut composé d'un mélange dudit ingrédient carboné et d'hydrogène à être activé pour finalement précipiter du diamant sur la surface du substrat (4) qui est chauffé au minimum à 600°C et au maximum à 1 200°C, ce procédé comprenant les étapes et les processus:

d'amener le matériau à rayonnement thermoélectronique (2) chauffé au minimum à 1 600°C à activer ledit gaz composé;

de produire un potentiel en reliant ledit matériau à rayonnement thermoélectronique (2) à l'électrode négative et la grille (3), disposée entre ledit matériau à rayonnement thermoélectronique (2) et le substrat (4) soumis au revêtement, à l'électrode positive en appliquant une source d'alimentation en courant continu;

d'extraire les électrons thermiques dudit matériau à rayonnement thermoélectronique (2) pour produire un plasma;

de produire un potentiel en reliant la grille (3) à l'électrode positive et le substrat (4) à l'électrode négative en appliquant une autre source d'alimentation en courant continu (7) pour produire un plasma tout en maintenant négatif le potentiel dudit substrat (4);

d'appliquer conjointement l'effet de l'activation produite par le matériau à rayonnement thermoélectronique (2) et une autre activation produite par la formation du plasma en courant continu; et de contrôler la pression régnant à l'intérieur du réacteur produisant le plasma à un minimum de 10 Torr et à un maximum de 400 Torr respectivement.

2. Procédé de synthèse du diamant selon la revendication 1, dans lequel le nombre proportionnel d'atomes de carbone par rapport au nombre d'atomes d'hydrogène du gaz brut composé dans ledit réacteur est au minimum de 0,01% et au maximum de 20%.

3. Procédé de synthèse du diamant selon la revendication 1, dans lequel ledit matériau à rayonnement thermoélectronique (2) est constitué sensiblement de l'un quelconque des éléments comprenant le tungstène (W), le tantale (Ta), le molybdène (Mo) ou $LaB_6$, ou le graphite.

4. Procédé de synthèse du diamant selon la revendication 1, dans lequel un minimum de 10 $W/cm^2$ d'énergie en courant continu est appliqué entre ledit matériau à rayonnement thermoélectronique (2) et la grille (3).

5. Procédé de synthèse du diamant selon la revendication 1, dans lequel 5 à 200 $W/cm^2$ d'énergie en courant continu sont appliqués entre ladite grille (3) et le substrat (4).

6. Procédé de synthèse du diamant selon la revendication 1, dans lequel la température sur la surface dudit substrat (4) est réglable suivant les besoins.

Fig. 1

Fig. 2